Europäisches Patentamt

European Patent Office

Office européen des brevets

(11) Veröffentlichungsnummer: **0 307 729**
**A1**

(12) **EUROPÄISCHE PATENTANMELDUNG**

(21) Anmeldenummer: **88114297.0**

(22) Anmeldetag: **01.09.88**

(51) Int. Cl.4: **G01R 15/00 , G01R 33/06**

(30) Priorität: **04.09.87 DE 3729712**

(43) Veröffentlichungstag der Anmeldung:
**22.03.89 Patentblatt 89/12**

(84) Benannte Vertragsstaaten:
**DE FR GB IT**

(71) Anmelder: **Siemens Aktiengesellschaft Berlin
und München**
**Wittelsbacherplatz 2**
**D-8000 München 2(DE)**

(72) Erfinder: **Kolb, Eberhard, Dipl.-Phys.**
**Belchenstrasse 60**
**D-7516 Karlsbad(DE)**

(54) **Prüfanordnung für elektronische Schaltungen.**

(57) Die Erfindung betrifft eine Prüfanordnung für elektronische Schaltungen mit einer Sensoranordnung zur Detektierung eines in einem elektrischen Leiter (L) fließenden Stromes. Um eine Fehlerbestimmung in Echtzeit, insbesondere auch in Schaltungen mit Busstruktur zu erleichtern, ist ein magnetfeldempfindlicher Sensor (S) symmetrisch zu dem Leiter (L) angeordnet und jeweils ein Halbsystem (S1, S2) des Sensors (S) vom gleichen magnetischen Fluß desselben Betrages, aber entgegengesetzter Richtung, durchdrungen.

Die Erfindung ist vor allem in Prüfautomaten für elektronische Baugruppen mit Busstruktur anwendbar.

$$\triangle U = -(R_1 / 2R_0) * U_B$$

**FIG 3**

## Prüfanordnung für elektronische Schaltungen

Die Erfindung bezieht sich auf eine Prüfanordnung für elektronische Schaltungen gemäß dem Oberbegriff des Anspruchs 1.

Aus "IBM Technical Disclosure Bulletin", Vol. 18, No. 8, January 1976, Seiten 2745 bis 2748 ist eine Sensoranordnung mit magnetfeldempfindlichen Sensoren bekannt, bei der magneto-resistive Permalloy-Sensoren in den Bereich eines magnetischen Feldes gebracht werden. Zur Detektierung des Stromes sind die Teil-Sensoren so angeordnet, daß sie vom Feld gleicher Richtung durchdrungen werden und durch entsprechende geometrische Anordnung ein entgegengesetzt gepoltes Ausgangssignal erzeugen. Dieses Differenzsignal wird in der Meßbrücke ausgewertet. Bei dieser Meßmethode ist neben einer systematischen Empfindlichkeit gegenüber Fremdfeldern mit einem relativ geringen Signalpegel zu rechnen. Der hier beschriebene Sensor hat den zu messenden Stromkreis fest eingebaut, und dieser Sensor ist gegenüber homogenen Feldüberlagerungen nicht meßsignalneutral. Diese Ausführung hat ihr spezielles Einsatzgebiet in Stromversorgungen. Die Empfindlichkeit des Sensors ist nur für den festen Einbau des zu detektierenden Stromkreises geeignet.

Es ist bereits weiterhin bekannt (Katalog von Hewlett Packard "Measurement, Computation, Systems - for Science, Engineering, Business, Industry, Education, Medicine" 1986, Seite 378), in Prüfanordnungen eine Fehlerortsbestimmung durch induktive Verfolgung, beispielsweise eines Kurzschlußstromes, mit induktiven Sonden durchzuführen (Current Tracing).

Weiterhin ist beispielsweise ein Meßverfahren auch mit sogenannten Barberpole-Permalloy-Feldplatten möglich. Dabei sind aber eine Reihe von ferromagnetischen Effekten unvermeidbar (u. a. Remanenzeffekte, Grenzfrequenz usw.).

Es gibt im wesentlichen zwei Verfahren mit einer Fehleranalyse unterhalb der Ebene von logischen Knoten innerhalb von elektronischen Schaltungen, die aber in der Regel nicht direkt in das Funktionsprüfsystem integriert sind. Diese Verfahren setzen deshalb auch ein "eingefrorenes" Prüflingsfehlerbild voraus und natürlich die Kenntnis des defekten Knotens. Weiterhin wird vorausgesetzt, daß der physikalische Fehler immer durch eine zu niedrige Impedanz in einem Bauteil oder an einer Leiterbahn repräsentiert werden kann. In diesem statischen Zustand wird nun am defekten Knoten ein Hilfswechselstrom eingespeist, der dann entweder mit einem Induktionsmeßkopf bis zur Stromsenke (Fehlerort) verfolgt wird, oder es werden die Stromanteile, die in ein Bauteil hinein- bzw. herausfließen, gemessen und aus diesem Verhältnis ebenfalls der Ort der Stromsenke bestimmt.

Alle diese Verfahren sind keine Echtzeitverfahren, was aber von der Dynamik einer Funktionsprüfung gefordert wird. Die bekannten Verfahren bieten auch keine Möglichkeit einer Software-Kontrolle für eine in der Prüftechnik unabdingbare Systemzuverlässigkeit.

Der Erfindung liegt die Aufgabe zugrunde, eine Prüfanordnung für elektronische Schaltungen, insbesondere mit Busstruktur, zu schaffen, bei der eine Fehlerbestimmung in Echtzeit ohne eine Beeinflussung der elektronischen Schaltung und mit einer Integration der Prüfschritte in eine systemgesteuerte Funktionsprüfung erreichbar ist.

Zur Lösung der gestellten Aufgabe weist eine Prüfanordnung der eingangs angegebenen Art die Merkmale des Kennzeichens des Anspruchs 1 auf. Vorteilhafte Weiterbildungen sind in den Unteransprüchen angegeben.

Vorteilhaft ist bei der neuen Methode das Ausnutzen des symmetrischen Feldaufbaus um einen symmetrischen Leiter, d. h. gleichzeitiges Ausnutzen der Geschlossenheit der Magnetfeldlinien bzw. des Kontinuitätsprinzips. Damit ist die absolut synchrone Magnetfeldmessung an zwei diametralen Orten möglich, die zu derselben geschlossenen Magnetfeldlinie gehören, wobei jedoch die Feldrichtung an beiden Orten genau entgegengesetzt ist. Das erfindungsgemäße Verfahren kann gegenüber den bekannten Verfahren als einziges berechtigterweise als Strommeßverfahren bezeichnet werden, da es die typischen Magnetfeldeigenschaften ausnutzt, die nur die Magnetfelder von Leiterströmen aufweisen, d. h., die Feldlinien sind den Formen von Leitern ähnlich und sie sind geschlossen. Aus Kontinuitätsgründen ist die Feldstärke an diametralen Punkten eines symmetrischen Leiters betragsmäßig gleich groß, aber genau entgegengerichtet. Somit nutzt der Stromsensor alle diese Eigenschaften in vorteilhafter Weise aus. Der Stromsensor nach Anspruch 1 mißt darüber hinaus auch in Anwesenheit eines homogenen Magnetfeldes nur das typische Feld eines Leiterstromes (z. B. Überlagerung des Erdmagnetfeldes). Sehr empfindliche bekannte Barberpole-Permalloy-Sensoren, die in bekannter Weise ausgeführt sind, haben dagegen immer das Überlagerungsproblem durch das Erdmagnetfeld.

Die wesentlichen, vorteilhaften Merkmale der erfindungsgemäßen Differenzmeßmethode sind somit der verhinderte Einfluß von Untergrund- oder homogenen Überlagerungsfeldern und sogar von inhomogenen Überlagerungen mit Gradienten, die nicht innerhalb der Größenordnung des Leiters selbst sind. Die laterale Empfindlichkeit dieses Meßverfahrens ist ca. Faktor 5 besser als die bekannte Methode. Letzteres ist sehr wichtig bei Überlagerungen von dicht geführten, benachbarten Leitern. Das Meßprinzip ist ein echtes Strommeßprinzip. Es eignet sich nur zur Messung von Strömen bzw. deren Felder. Homogene, gleichgerichtete Felder führen bei diesem Stromsensor zu keinem Signal, z. B. das Erdmagnetfeld, wobei das Differenzsignal also aus der Topographie eines von einem stromführenden Leiter gebildeten Feldes erzeugt wird.

Echtzeit-Funktionsprüfungen von digitalen Schaltungen erfassen logische Funktionen und erkennen deshalb physikalische Fehler auch auf der logischen Ebene. Entsprechende Fehlerlokalisierungsverfahren können damit ebenfalls eine Fehlerlokalisierung nur auf logischer Ebene leisten. Eine Fehlerdiagnose auf dieser Ebene bedeutet einen abweichenden Logikpegel an einem inneren Knoten der Schaltung zu einem definierten Zeitpunkt.

Aber schon der einfachste denkbare Knoten ist durch zwei Bausteine und eine Verbindungsleitung definiert. Sowohl der treibende Baustein als auch der Empfängerbaustein oder die Verbindungsleitung selbst kann defekt sein. Mithin kann ein defekter Knoten auf der Logikebene durch eine ganze Reihe physikalischer Fehler verursacht sein. Eine Fehlerdiagnose auf dieser Ebene ist also bereits im einfachsten Fall fast immer mehrdeutig.

Betrachtet man jedoch reale Baugruppen, können 20 und noch mehr Bausteine und das dazugehörige Leiterbahnennetzwerk eine Vielfalt von Bauteil- und Leiterbahnfehlern an einem einzigen Knoten bedeuten, die aber auf der Logikebene alle zur selben Fehlerdiagnose gehören.

Um nun an einem defekten Knoten (Logikpegelfehler oder Pulsfehler) ein defektes Bauteil oder einen Leiterbahnfehler genau zu bestimmen, müssen weiterführende, über die logische Ebene hinausgehende Meßgrößen zugänglich gemacht werden.

Am vorteilhaftesten geschieht dies erfindungsgemäß durch die Bestimmung der Stromvektoren an den durch den Knoten verbundenen Bausteinen, d. h. die Bestimmung der Richtung des Stromes und die Größe des Stroms, der vom Logikpegel und den Lastfaktoren abhängig ist.

Die Erfindung wird anhand der Figuren erläutert, wobei

Figur 1 ein Schnittbild durch einen elektrischen Leiter mit seinen Feldlinien und einem Sensor,

Figur 2 die y-Komponenten eines Magnetfeldes um einen runden und einen rechteckigen Leiter,

Figur 3 ein Ersatzschaltbild eines Ausführungsbeispiels einer Sensoranordnung und

Figur 4 ein Ausführungsbeispiel einer in einem Tastkopf angeordneten Sensoranordnung darstellt.

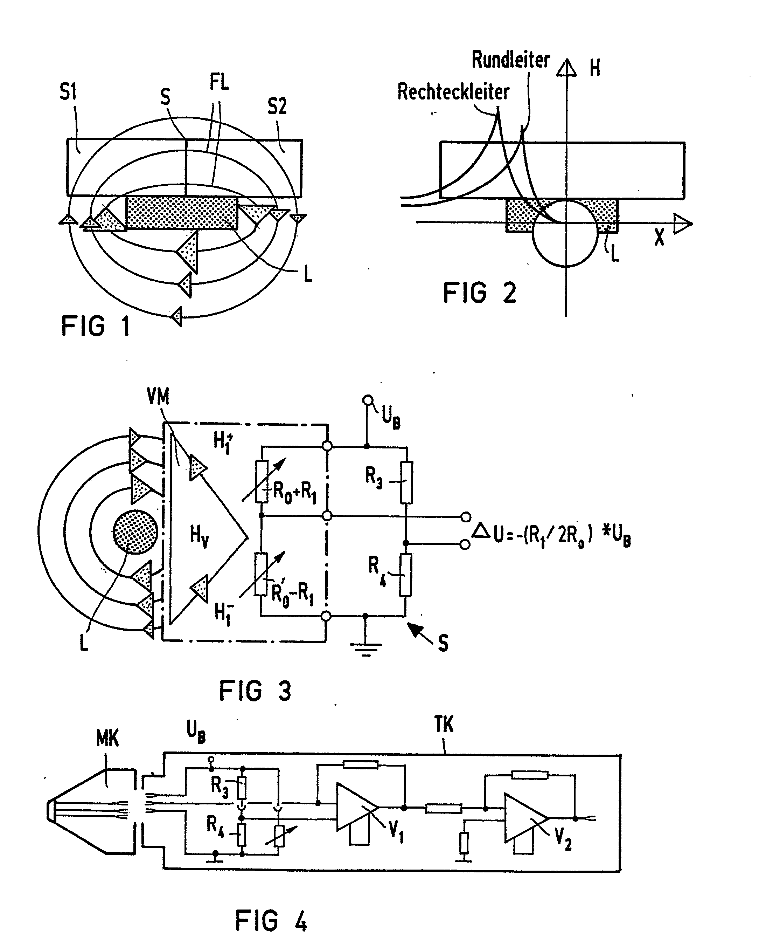

In der Figur 1 sind magnetische Feldlinien FL um einen rechteckigen Leiter L dargestellt; die Feldstärke nimmt dabei mit der Entfernung von der Leiteroberfläche ab. Bei Rechteckleitern, wie sie vor allem auf Leiterplatten und bei Anschlüssen von inte grierten Schaltungen vorkommen, können dadurch die Feldverhältnisse vorteilhaft ausgenutzt werden. Im Bereich der Feldlinien FL ist oberhalb des Leiters L ein magnetfeldabhängiger Halbleiter als magnetischer Sensor S mit zwei Halbsystemen S1 und S2 symmetrisch zum Leiter L angeordnet. Da die von Strömen erzeugten Feldlinien geschlossen sein müssen, ergibt sich bei Leitern mit rechteckigem Querschnitt im Vergleich zu Leitern mit rundem Querschnitt bei gleichem Leiterquerschnitt ein größerer magnetischer Fluß durch die Halbsysteme des magnetfeldabhängigen Halbleiters. Der Grund für den größeren Fluß ist die größere Dichte der ellipsenartigen Feldlinien an den kurzen Seiten des Rechtecks.

Eine Berechnung der Feldstärke liefert dasselbe Ergebnis, was in der Figur 2 dargestellt ist. Der magnetische Fluß ist hierbei proportional der Flächen unter den Kurven für den Rechteckleiter L bzw. den Rundleiter jeweils für ein Halbsystem S1 oder S2. Es ist hierbei vorausgesetzt, daß der magnetfeldabhängige Halbleiter eine Vorzugsrichtung hat, d. h., es wird z. B. nur die y-Komponente des Magnetfeldes vom Leiterstrom wirksam. Eine besondere Eignung von Differentialfeldplatten als magnetischer Sensor S ergibt sich unter anderem aus der Tatsache, daß der gesamte Halbleiter aus demselben Kristallbereich stammt, wodurch sich thermische Effekte immer symmetrisch und damit meßsignalneutral auswirken. Es ist aber auch beispielsweise ein Differentialhallgenerator hier anwendbar oder ein Barberpole-Permalloy-Differentialsensor mit geeigneter Vormagnetisierung.

Das Ersatzschaltbild nach Figur 3 zeigt eine vollständige Anordnung mit einer Differentialfeldplatte als Sensor S, die aus zwei gleich großen, magnetfeldabhängigen Widerständen $R_0$ und $R_0^{'}$ besteht, die in Reihe geschaltet sind.

Im gestrichelten Bereich der Figur 3 befindet sich ein Meßkopf MK. Er besteht aus der Differentialfeldplatte und einer Vormagnetisierungseinrichtung VM (z. B. Permanentmagnet) mit dem Feld $H_v$. Mit diesem Vormagnetisierungsfeld wird die zunächst quadratische Kennlinie der magnetfeldabhängigen Widerstände $R_0$ und $R_0^{'}$ linearisiert. Wird ein stromdurchflossener Rund leiter L gemäß Figur 3 symmetrisch positioniert, ergibt sich für die magnetfeldabhängigen Widerstände $R_0$ und $R_0^{'}$ ein überlagertes

Gesamtfeld von $(H_v + H_1^+)$ und für das andere Halbsystem ein Gesamtfeld von $(H_v - H_1^-)$. Analog dazu erhält man eine entsprechende Widerstandserhöhung $(R_0 + R_1)$ und eine Widerstandserniedrigung $(R_0 - R_1)$.

Wird die Differentialfeldplatte entsprechend Figur 3 mit Widerständen $R_3$ und $R_4$ zu einer Vollbrücke ergänzt, ergibt sich ein Spannungssignal

$$\Delta U = - (R_1/2R_0) \cdot U_B \qquad (1)$$

im Brückenzweig.

Kehrt man die Stromrichtung im Rundleiter L um, kehrt sich das Vorzeichen von $\Delta U$ ebenso um. Es ergibt sich nunmehr:

$$(\Delta U = + (R_1/2R_0) \cdot U_B) \qquad (2)$$

Schaltet man den Strom ab ($H_1^+$, $H_1^- = 0$), wird also kein Feld mehr überlagert und somit $R_1 = 0$ wird, ist die Brücke abgeglichen und somit $\Delta U = 0$.

In der Formel $(\Delta U = \pm (R_1/2R_0) \cdot U_B \qquad (3)$ ist $\Delta U$ proportional $R_1$. Sowohl $R_0$ als auch die Brückenversorgungsspannung $U_B$ sind konstant. Die Widerstandsänderung $R_1$, die durch den Leiterbahnstrom verursacht wird, ist sehr klein gegen $R_0$, und die Kennlinie ist praktisch linear. Der Sensor S liefert also einen Stromvektor, der dem Leiterbahnstrom proportional ist.

Bei dem Ausführungsbeispiel nach der Figur 4 ist der Meßkopf MK aus Kunststoff (beispielsweise Polytetrafluoräthylen) in einen Tastkopf TK eingebaut. In der Spitze des Meßkopfs MK ist eine Differentialfeldplatte (beispielsweise Siemens, Typ: FP110 D155) und ein Miniaturpermanentmagnet (beispielsweise Vacuumschmelze GmbH, Werkstoff: VACOMAX 145) eingeklebt. Die drei Drahtanschlüsse A der Feldplatte führen unmittelbar auf einen am oberen Ende befindlichen, hier nicht explizit dargestellten Stecker. Im anschließenden Rumpf des Tastkopfs TK befindet sich ein Spannungsteiler mit zwei hochgenauen (5 ppm) 1 Kiloohm-Widerständen $R_3$, $R_4$, die gemeinsam mit den beiden Feldplattenwiderständen $R_0$, $R_0^1$ die Vollbrücke bilden, die noch zusätzlich abgeglichen werden kann. Das Brückensignal führt direkt über einen zweistufigen Verstärker $V_1$, $V_2$ auf den Ausgang des Tastkopfs TK und kann als Ausgangssignal zur Bestimmung des Stromvektors herangezogen werden.

## Ansprüche

1. Prüfanordnung für elektronische Schaltungen
- mit einer magnetfeldempfindliche Sensoren (S) in einem Meßbrückenzweig enthaltenden Sensoranordnung, die zur Detektierung eines Stromes in den Bereich des magnetischen Feldes eines Leiters (L) gebracht ist,
**dadurch gekennzeichnet, daß**

- der Leiter (L) im wesentlichen symmetrisch zu seiner Längsachse aufgebaut ist,
- die Sensoranordnung quer zur Längsachse des Leiters (L) angeordnet ist, wobei jeweils ein Halbsystem symmetrisch beiderseits zur Längsachse des Leiters (L) angeordnet ist und jeweils die gleiche Richtungsempfindlichkeit hinsichtlich der vom Strom erzeugten Feldlinien aufweist und jeweils beide Halbsysteme (S1, S2) vom gleichen magnetischen Fluß desselben Betrages, aber entgegengesetzter Richtung, durchdrungen sind.

2. Prüfanordnung nach Anspruch 1, **dadurch gekennzeichnet, daß**
- der magnetfeldempfindliche Sensor (S) eine Differentialfeldplatte aus Halbleitermaterial ist.

3. Prüfanordnung nach Anspruch 2, **dadurch gekennzeichnet, daß**
- die Sensoranordnung in einem Tastkopf (TK) untergebracht ist und der Tastkopf (TK) eine Vormagnetisierungseinrichtung (VM) enthält zur Linearisierung der Feldplattenkennlinie und zur Optimierung der Empfindlichkeit.

4. Prüfanordnung nach Anspruch 2 oder Anspruch 3, **dadurch gekennzeichnet, daß**
- die Differentialfeldplatte aus zwei gleich großen magnetfeldabhängigen Widerständen ($R_0$, $R_0^1$) besteht, die in Reihe geschaltet einen Zweig der Meßbrücke darstellen.

S1    S    FL    S2

L

**FIG 1**

Rundleiter

Rechteckleiter

H

X

L

**FIG 2**

VM

$U_B$

$H_1^+$

$R_0 + R_1$

$R_3$

$H_V$

$R_0' - R_1$

$R_4$

$H_1^-$

$\triangle U = -(R_1 / 2R_0) *U_B$

L

S

**FIG 3**

MK    $U_B$    TK

$R_3$

$R_4$

$V_1$

$V_2$

**FIG 4**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | IBM TECHNICAL DISCLOSURE BULLETIN, Band 18, Nr. 8, Januar 1976, Seiten 2745-2748, New York, US; C.H. BAJOREK et al.: "Magnetoresistive current sensor" * Seite 2746, Absatz 1 - Seite 2747, Absatz 1; Figuren 1,2 * | 1 | G 01 R 15/00 G 01 R 33/06 |
| D,A | Idem * Seite 2747, letzter Absatz - Seite 2748, Absatz 1; Figuren 3,5,6 * --- | 4 | |
| A | US-A-3 365 665 (HOOD) * Spalte 2, Zeile 71 - Spalte 3, Zeile 6; Figur 2 * --- | 1 | |
| A | K.-W. DUGGE et al.: "Grundlagen der Elektronik", 1985, Seiten 351,372-375, Vogel-Buchverlag, Würzburg, DE * Seite 351, Absatz 1; Seite 373, letzter Absatz - Seite 375, letzter Absatz; Figuren 19,29 * --- | 2 | RECHERCHIERTE SACHGEBIETE (Int. Cl.4) G 01 R |
| A | DE-A-1 516 123 (LIST) * Anspruch 1; Figur 1 * --- | 3 | |
| A | IBM TECHNICAL DISCLOSURE BULLETIN, Band 18, Nr. 11, April 1976, Seiten 3847-3851, New York, US; J.S. FENG: "Self-biased magnetoresistive bridge configuration for current measurement" * Seite 3848, Absatz 1 * --- -/- | 3 | |

Der vorliegende Recherchenbericht wurde für alle Patentansprüche erstellt

| Recherchenort | Abschlußdatum der Recherche | Prüfer |
|---|---|---|
| DEN HAAG | 01-12-1988 | HARRISON R.J. |

Europäisches
Patentamt

**EUROPÄISCHER RECHERCHENBERICHT**

Nummer der Anmeldung

EP 88 11 4297

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | JOURNAL OF PHYSICS E- SCIENTIFIC INSTRUMENTS, Band 19, Nr. 7, July 1986, Seiten 502-515, The Institute of Physics, Bristol, GB; W. KWIATKOWSKI et al.: "The permalloy magnetoresistive sensors - properties and applications" ----- | | |

RECHERCHIERTE SACHGEBIETE (Int. Cl.4)

Der vorliegende Recherchenbericht wurde für alle Patentansprüche erstellt

| Recherchenort | Abschlußdatum der Recherche | Prüfer |
|---|---|---|
| DEN HAAG | 01-12-1988 | HARRISON R.J. |